# EUROPEAN PATENT SPECIFICATION

(11) **EP 2 250 031 B1**
(45) Date of publication and mention of the grant of the patent: **20.11.2013**
(21) Application number: 09712040.6
(22) Date of filing: 19.02.2009
(51) Int. Cl.: B42D 15/00, B42D 15/10, G02F 1/163

(54) **THIN FILM DISPLAY**
DÜNNSCHICHTANZEIGEVORRICHTUNG
DISPOSITIF D'AFFICHAGE À COUCHE MINCE

(30) Priority: 19.02.2008 GB 0803011
(43) Date of publication of application: 17.11.2010
(73) Proprietor: D W Spinks (Embossing) Ltd, London WC1R 4AG (GB)
(72) Inventor: SPINKS, Gary, Donald, Brimsdown, EN3 7XF (GB)
(74) Representative: Critten, Matthew Peter
(86) International application number: PCT/GB2009/000449
(87) International publication number: WO 2009/103973

(56) References cited:
- WO-A-00/36560
- WO-A-03/054807
- WO-A-2008/017864
- FR-A- 2 873 134
- GB-A- 2 438 384

## Description

The present invention relates to devices, including but not limited to banknotes, incorporating a thin film display. More particularly, but not exclusively, the thin film display performs the function of a visible security feature.

It is known to provide a number of valuable products, such as bank notes, cheques, and passports, with some form of visible counterfeit-protection. A number of visible counterfeit-protection features are known in the art. For example, credit cards are often provided with holograms. Such features typically have the advantage that they are readily recognisable to the general public, thereby providing a security feature that is easy to describe to the general public.

As technology improves, existing visible security features, such as holograms become easier and cheaper to counterfeit. Accordingly, there is a demand for alternative visible security features to those known in the art.

One known solution is to provide a liquid crystal display to provide changing visible patterns. Problems with such displays include the provision of a power source, the size of the security features and the cost.

Furthermore, in order to be incorporated in products, such as banknotes, that need to be cheap to produce and long lasting, any security feature should be cheap to produce, cheap to operate and long lasting. Security features should also be easy to describe to the general public and easy to use.

WO03/054807A1 described as authenticity feature for a sheet-type value document, for example a banknote. The authenticity feature is said to be reliably verifiable in a mechanical manner or by humans, and is said not to be copyable in a deceptive manner using technical copying means. The authenticity feature is said to be made by an electro-optical and/or acoustic reproduction device integrated into the value document.

The present invention seeks to address at least some of the problems outlined above.

The invention provides a device comprising a piezoelectric element and an electrochromic element, wherein: the piezoelectric element has an output adapted to provide a voltage in response to an activation of the piezoelectric element; the electrochromic element has an input coupled to the output of said piezoelectric element; and the electrochromic element provides a visible output dependent on the output of said piezoelectric element, and wherein the device has a thickness of 60 microns or less.

Thus the device is in the form of a thin film. Preferably, the device has a thickness of less than 50 microns, less than 40 microns, less than 30 microns or even less than 20 microns.

The device is preferably arranged to be incorporated in a valuable product.

In an example form of the invention, the piezoelectric element is activated by mechanically stressing the piezoelectric element. For example, the piezoelectric element may be mechanically stressed by flexing or bending.

The visible output of the electrochromic element may have a colour that changes in response to a signal output by the piezoelectric element.

The visible output of the electrochromic element may be a change from a colourless state of the electrochromic element to a coloured state, or *vice versa.* The change from the colourless state to the coloured state, or vice versa, may result in a latent image being revealed.

The visible output of the electrochromic element may provide a message in response to a signal output by the piezoelectric element.

The visible output of the electrochromic element may provide a message at a predetermined time. For example, a message may be provided when a product has reached its best-before or sell-by date.

In some forms of the invention, the electrochromic element is adapted to interact with circuit elements that do not form part of the said device.

The device may be mounted on a rigid substrate, such as a polycarbonate plastic. Alternatively, the device may be mounted on a flexible substrate, such as paper.

The present invention also provides a product incorporating a device according to the invention as described above. For example, the product may be a paper product, such as a banknote. In some forms of the invention, the product is a branded product, with the visible output of the electrochromic element being related to the brand in some way.

The device may have any of the features described above in respect of the first-described aspect of the invention.

By way of example only, embodiments of the present invention will now be described with reference to the accompanying drawings, of which:
Figure 1 is a schematic block diagram showing the functionality of an example embodiment of the present invention;
Figure 2 is a schematic cross-section of the example embodiment of Fig. 1;
Figure 3 is a plan view of a credit card incorporating features of the present invention; and
Figure 4 is a plan view of a paper product incorporating features of present invention.

The invention relates to a device including a visible security feature comprising a thin-film device. The device comprises a piezoelectric element connected to an electrochromic element.

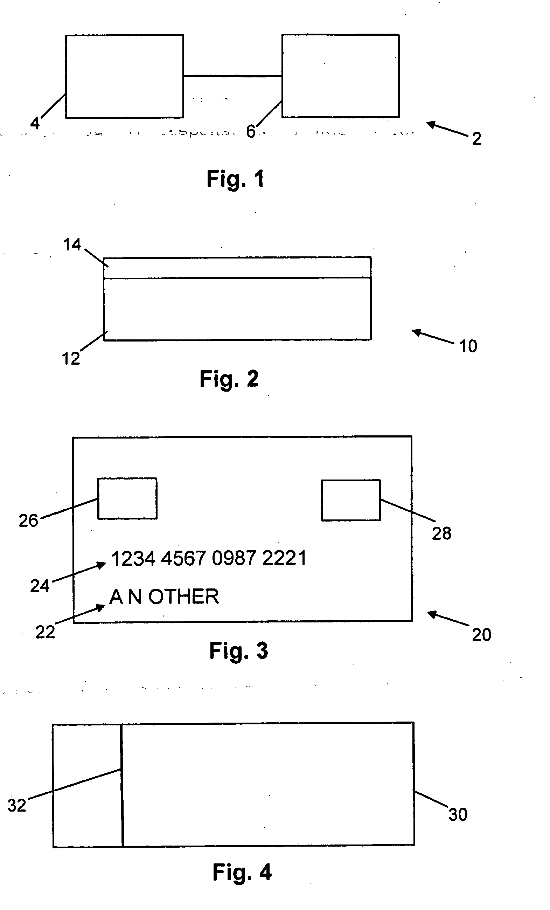

Figure 1 is a highly schematic block diagram, indicated generally by the reference numeral 2, demonstrating the functionality of the present invention. The block diagram 2 comprises a piezoelectric element 4 and an electrochromic element 6. The piezoelectric element 4 may take the form of a film.

As is well known in the art, piezoelectric materials can be used to generate an electric potential in response to an applied mechanical stress, for example in the form of compression or flexing of the piezoelectric material.

The piezoelectric element 4 has an output coupled to the input of the electrochromic element 6. Electrochromic materials have a colour that is changed on receipt of an electric current. Accordingly, the colour of the electrochromic element 6 can be changed by causing the piezoelectric element 4 to output a suitable current. This can be readily achieved by simply flexing or otherwise stressing the piezoelectric element 4.

Figure 2 shows a highly schematic cross-section of a circuit, indicated generally by the reference numeral 10, in accordance with the present invention. The circuit 10 comprises a substrate 12 and a multi-layer film 14.

In some forms of the invention, the substrate 12 is rigid; polycarbonate plastics are suitable materials. In other forms of the invention, the substrate 12 is flexible; for example, paper, thin films or flexible polymers may be used.

The multi-later film 14 comprises a plurality of layers of piezoelectric film and electrochromic film. This is the active layer of the present invention.

Figure 3 shows a credit card, indicated generally by the reference numeral 20, incorporating example features of present invention. The credit card 20 includes an area 22 for providing textual information, such as the name of the cardholder, an area 24 for providing the number of the card, an integrated circuit 26 and a display 28. The display 28 may, for example, be the circuit 10 described above for the first example embodiment of the invention with reference to Figure 2.

When the credit card 20 is flexed, the piezoelectric element of the display 28 is stressed, thereby causing a voltage to be applied to the electrochromic film of the display 28. This results in a change in the colour of the display, thereby providing an indication that the card is genuine.

Figure 4 shows a sheet of paper, indicated generally by the reference numeral 30, incorporating example features of the present invention. The paper 30, which in this example is a banknote, comprises a thread 32. The thread 32 may be formed from the circuit 10 described above with reference to Figure 2. When, in use, the paper 30 is handled, mechanical stressing of the thread 32 occurs, resulting in a change of the colour of the electrochromic film. This leads to a visible effect that is readily recognisable to the user, thereby providing an indication that the paper product is genuine.

In some forms of the invention, the circuit 10 is adapted to communicate with other electronic media, thereby enabling the device to be programmed. The connection could be provided wirelessly; for example, an infra-red or magnetic signal could be provided.

The present invention is not limited to use with credit cards and banknotes. For example, the film 10 could be incorporated into a wide variety of products ranging from identity cards to branded products. When used with branded products, for example, the logo of the relevant brand could be arranged to change colour whenever the product is mechanically stressed.

## Claims

1. A device comprising a piezoelectric element (4) and an electrochromic element (6), wherein:
the piezoelectric element (4) has an output adapted to provide a voltage in response to an activation of the piezoelectric element (4);
the electrochromic element (6) has an input coupled to the output of said piezoelectric element (4); and
the electrochromic element (6) provides a visible output dependent on the output of said piezoelectric element (4), and wherein the device has a thickness of 60 microns or less.

2. A device as claimed in claim 1, wherein the piezoelectric element (4) is activated by mechanically stressing the piezoelectric element (4).

3. A device as claimed in claim 1 or claim 2, wherein the visible output of the electrochromic element (6) has a colour that changes in response to a signal output by the piezoelectric element (4).

4. A device as claimed in any one of claims 1 to 3, wherein the visible output of the electrochromic element (6) provides a message in response to a signal output by the piezoelectric element (4).

5. A device as claimed in any of claims 1 to 4, wherein the visible output of the electrochromic element (6) provides a message at a predetermined time.

6. A device as claimed in any of claims 2 to 5, wherein said electrochromic element (6) is adapted to interact with circuit elements that do not form part of the said device.

7. A device as claimed in any preceding claim, wherein said device is mounted on a rigid substrate (12).

8. A device as claimed in any one of claims 1 to 6, wherein said device is mounted on a flexible substrate (12).

9. A product incorporating a device as claimed in any one of claims 1 to 8.

10. A product as claimed in claim 9, said product being a paper product (30).

11. A product as claimed in claim 10, said paper product being a banknote.

## Patentansprüche

1. Einrichtung mit einem piezoelektrischen Element (4) und einem elektrochromen Element (6),
wobei das piezoelektrische Element (4) einen Ausgang aufweist, der dazu ausgelegt ist, eine Spannung in Abhängigkeit von einer Aktivierung des piezoelektrischen Elementes (4) zu liefern;
wobei das elektrochrome Element (6) einen Eingang aufweist, der mit dem Ausgang des piezoelektrischen Elementes (4) verbunden ist; und
wobei das elektrochrome Element (6) ein sichtbares Ausgangssignal liefert, das von dem Ausgangssignal des piezoelektrischen Elementes (4) abhängt, und wobei die Einrichtung eine Dicke von 60 µm oder weniger besitzt.

2. Einrichtung nach Anspruch 1,
wobei das piezoelektrische Element (4) aktiviert wird durch mechanisches Beanspruchen des piezoelektrischen Elementes (4).

3. Einrichtung nach Anspruch 1 oder 2,
wobei das sichtbare Ausgangssignal des elektrochromen Elementes (6) eine Farbe besitzt, die sich in Abhängigkeit von einem Signal ändert, das von dem piezoelektrischen Element (4) abgegeben wird.

4. Einrichtung nach einem der Ansprüche 1 bis 3,
wobei das sichtbare Ausgangssignal des elektrochromen Elementes (6) eine Nachricht in Abhängigkeit von einem Signal liefert, das von dem piezoelektrischen Element (4) abgegeben wird.

5. Einrichtung nach einem der Ansprüche 1 bis 4,
wobei das sichtbare Ausgangssignal des elektrochromen Elementes (6) eine Nachricht zu einem vorgegebenen Zeitpunkt liefert.

6. Einrichtung nach einem der Ansprüche 2 bis 5,
wobei das elektrochrome Element (6) dazu ausgelegt ist, mit Schaltungselementen zusammenzuwirken, die keinen Teil der Einrichtung bilden.

7. Einrichtung nach einem der vorhergehenden Ansprüche,
wobei die Einrichtung an einem steifen Substrat (12) angebracht ist.

8. Einrichtung nach einem der Ansprüche 1 bis 6,
wobei die Einrichtung an einem flexiblen Substrat (12) angebracht ist.

9. Produkt,
in das eine Einrichtung nach einem der Ansprüche 1 bis 8 integriert ist.

10. Produkt nach Anspruch 9,
wobei das Produkt ein Papierprodukt (30) ist.

11. Produkt nach Anspruch 10,
wobei das Papierprodukt eine Banknote ist.

## Revendications

1. Dispositif comprenant un élément piézoélectrique (4) et un élément électrochromique (6), dans lequel :
l'élément piézoélectrique (4) présente une sortie conçue pour fournir une tension en réponse à une activation de l'élément piézoélectrique (4) ;
l'élément électrochromique (6) présente une entrée couplée à la sortie dudit élément piézoélectrique (4) ; et
l'élément électrochromique (6) fournit une sortie visible dépendante de la sortie dudit élément piézoélectrique (4) et dans lequel le dispositif possède une épaisseur inférieure ou égale à 60 microns.

2. Dispositif selon la revendication 1, dans lequel l'élément piézoélectrique (4) est activé en exerçant une contrainte mécanique sur l'élément piézoélectrique (4).

3. Dispositif selon la revendication 1 ou la revendication 2, dans lequel la sortie visible de l'élément électrochromique (6) possède une couleur qui change en réponse à un signal généré par l'élément piézoélectrique (4).

4. Dispositif selon l'une quelconque des revendications 1 à 3, dans lequel la sortie visible de l'élément électrochromique (6) fournit un message en réponse à un signal généré par l'élément piézoélectrique (4).

5. Dispositif selon l'une quelconque des revendications 1 à 4, dans lequel la sortie visible de l'élément électrochromique (6) fournit un message à un instant prédéterminé.

6. Dispositif selon l'une quelconque des revendications 2 à 5, dans lequel ledit élément électrochromique (6) est conçu pour interagir avec des éléments de circuit qui ne font pas partie dudit dispositif.

7. Dispositif selon l'une quelconque des revendications précédentes, dans lequel ledit dispositif est monté sur un substrat (12) rigide.

8. Dispositif selon l'une quelconque des revendications 1 à 6, dans lequel ledit dispositif est monté sur un substrat (12) souple.

9. Produit comprenant un dispositif selon l'une quelconque des revendications 1 à 8.

10. Produit selon la revendication 9, ledit produit étant un produit en papier (30).

11. Produit selon la revendication 10, ledit produit en papier étant un billet de banque.
